# EUROPEAN PATENT APPLICATION

(11) **EP 4 671 817 A1**
(43) Date of publication of application: **31.12.2025**
(21) Application number: 24783998.8
(22) Date of filing: 05.03.2024
(51) Int. Cl.: G01S 7/481, G01S 7/483

(54) **MEMS MICROMIRROR SYSTEM, LASER RADAR SYSTEM, AND VEHICLE**

(30) Priority: 06.04.2023 CN 202310373141; 28.02.2024 CN 202410225038
(71) Applicant: Huawei Technologies Co., Ltd., Shenzhen, Guangdong 518129 (CN)
(72) Inventor: DONG, Xiaoshi, Shenzhen, Guangdong 518129 (CN); CHANG, Zhiwu, Shenzhen, Guangdong 518129 (CN); ZHAO, Fei, Shenzhen, Guangdong 518129 (CN); XU, Jinghui, Shenzhen, Guangdong 518129 (CN)
(74) Representative: Pfenning, Meinig & Partner mbB
(86) International application number: PCT/CN2024/080076
(87) International publication number: WO 2024/207913

(57) **Abstract**

A MEMS micromirror system, a lidar system, and a vehicle relate to the field of lidar technologies, and can improve an impact resistance capability of the MEMS micromirror system. A movable portion (110) in the MEMS micromirror system includes a movable structure (112), a reflective structure (111), and a reinforcing structure (113). A fastened portion (130) includes at least two fastened structures, and each fastened structure includes a first fastened layer (131) and a second fastened layer (132). The first fastened layer (131) is located above the second fastened layer (132), and the first fastened layer (131) is thinner than the second fastened layer (132). A support portion includes a first cantilever beam (121) and a second cantilever beam (122). One end of each of the first cantilever beam (121) and the second cantilever beam (122) is connected to the reinforcing structure (113), and the other end is connected to the second fastened layer (132). Overall thicknesses of the first cantilever beam (121) and the second cantilever beam (122) are greater than or equal to an overall thickness of the first fastened layer (131), and are greater than an overall thickness of the movable structure (112).

## Description

This application claims priorities to Chinese Patent Application No. 202310373141.7, filed with the China National Intellectual Property Administration on April 6, 2023 and entitled "MEMS MICROMIRROR SYSTEM", and to Chinese Patent Application No. 202410225038.2, filed with the China National Intellectual Property Administration on February 28, 2024 and entitled "MEMS MICROMIRROR SYSTEM, LIDAR SYSTEM, AND VEHICLE", both of which are incorporated herein by reference in their entireties.

### TECHNICAL FIELD

This application relates to the field of lidar technologies, and in particular, to a MEMS micromirror system, a lidar system, and a vehicle.

### BACKGROUND

With further popularization of automobile intelligence, by virtue of features such as a light weight, low costs, a small size, and low energy consumption, a lidar with a MEMS (Micro-Electro-Mechanical System) micromirror system is continuously upgraded and evolved as a core sensor of an intelligent automobile, and is continuously expanded in other fields such as security cameras, self-driving, and intelligent robots.

A MEMS micromirror system applied to the lidar field usually needs a larger reflector surface. The larger reflector surface means that optical pulses emitted by the system are more focused, an emission distance is longer, and an optical pulse signal received by the system is stronger.

However, the following reliability problem exists in an existing large-mirror-surface MEMS micromirror system. Because a relatively large MEMS mirror surface is used, stress on a micromirror in a scanning process increases, thereby reducing vibration resistance and impact resistance capabilities of the MEMS micromirror system. A silicon-based support portion, as a main moving component in the MEMS micromirror system, usually has low and discontinuous rigidity. In an in-vehicle environment, the silicon-based support portion bears relatively large stress when being subject to vibration and impact, and is prone to fracture, thereby affecting overall performance of the micromirror system.

### SUMMARY

Embodiments of the present invention provide a MEMS micromirror system, a lidar system, and a vehicle, which are applied to the lidar field, to improve impact resistance performance of the MEMS micromirror system, and further improve performance of a lidar. To achieve the foregoing objective, embodiments of the present invention provide the following technical solutions.

According to a first aspect, an embodiment of the present invention provides a MEMS micromirror system. The MEMS micromirror system includes a drive portion, a movable portion, a fastened portion, and a support portion. The movable portion further includes a movable structure, a reflective structure, and a reinforcing structure. The drive portion is configured to drive the movable structure to translate or rotate relative to a fastened structure. The fastened portion includes at least two fastened structures, and each fastened structure includes a first fastened layer and a second fastened layer. The first fastened layer is located above the second fastened layer, and an overall thickness of the first fastened layer is less than an overall thickness of the second fastened layer. The support portion includes at least a first cantilever beam and a second cantilever beam. One end of each of the first cantilever beam and the second cantilever beam is directly connected to the reinforcing structure, and the other end is directly or indirectly connected to the second fastened layer. Overall thicknesses of the first cantilever beam and the second cantilever beam are greater than or equal to the overall thickness of the first fastened layer, and are greater than an overall thickness of the movable structure. The overall thickness is a maximum thickness of the structure in a vertical direction.

Two ends of each cantilever beam in the solution of this application are not directly connected to the movable portion, but are respectively connected to the reinforcing structure and the second fastened layer, and the second fastened layer is thicker than the first fastened layer. Therefore, in this application, compared with a MEMS micromirror system in a conventional technology, because two ends of each of the first cantilever beam and the second cantilever beam are connected to a thicker device layer, this helps the cantilever beams have relatively continuous and smooth rigidity under stress, thereby ensuring relatively high boundary reliability of the cantilever beams.

With reference to the first aspect, in a possible implementation, the reflective structure is located above the movable structure and is attached to the movable structure, and the reflective structure is configured to implement light deflection and modulation functions. The reinforcing structure is located below the movable structure and is configured to support the movable structure, and an overall thickness of the reinforcing structure is greater than the overall thickness of the movable structure. The thicker reinforcing structure is configured to support the movable structure, so that rigidity in a Z direction is higher compared with that in a conventional technology, and an impact resistance capability of the MEMS micromirror system in the Z direction can be improved.

With reference to the first aspect, in a possible implementation, the reflective structure, the movable structure, and the first fastened layer are located at a first device layer, and the reinforcing structure and the second fastened layer are located at a second device layer. An overall thickness of the first device layer is less than an overall thickness of the second device layer. Because the thinner first device layer is located above the thicker second device layer, relatively high boundary reliability of the MEMS micromirror system can be ensured.

With reference to the first aspect, in a possible implementation, the MEMS micromirror system further includes a movable outer frame, a third cantilever beam, and a fourth cantilever beam. One end of each of the third cantilever beam and the fourth cantilever beam is directly connected to the movable outer frame, and the other end is directly connected to the second fastened layer. One end of each of the first cantilever beam and the second cantilever beam is indirectly connected to the second fastened layer through the movable outer frame, the third cantilever beam, and the fourth cantilever beam, and the other end is directly connected to the reinforcing structure. The third cantilever beam and the fourth cantilever beam are added, so that the MEMS micromirror system may implement two-dimensional rotation, and therefore may be applied to more scanning modes such as dual-axis resonance, dual-axis non-resonance, single-axis resonance, and single-axis non-resonance.

With reference to the first aspect, in a possible implementation, a width of each end of any one or more of the first cantilever beam, the second cantilever beam, the third cantilever beam, and the fourth cantilever beam is greater than a width of a middle. The cantilever beam has features of a small size and a length far greater than a thickness, and is prone to fracture under an action of an external force. In this application, widths of two ends of the cantilever beam are widened, so that stress that is applied to the cantilever beam and that is transferred to the fastened portion and the movable portion is further dispersed, thereby improving impact resistance reliability at boundaries of different device layers.

With reference to the first aspect, in a possible implementation, a thickness of any one or more of the first cantilever beam, the second cantilever beam, the third cantilever beam, and the fourth cantilever beam is not less than 100 micrometers, the width of the middle is not less than 20 micrometers, and a total length is between 0.5 millimeters and 10 millimeters.

With reference to the first aspect, in a possible implementation, a structure of any one or more of the first cantilever beam, the second cantilever beam, the third cantilever beam, and the fourth cantilever beam is of a straight-line shape or a fold-line shape. The fold-line structure increases an effective length of the cantilever beam in a case of a same actual length, thereby improving a stress resistance capability of the cantilever beam. In addition, when the MEMS micromirror system is subject to an external force, the cantilever beam of a curved structure is bent and deformed to provide necessary scalability and a rebound force, thereby effectively reducing deformation of a reflector surface due to stress, and improving a service life.

With reference to the first aspect, in a possible implementation, an area of the reflective structure is not greater than an area of the movable structure.

With reference to the first aspect, in a possible implementation, the reinforcing structure is an annular closed structure.

With reference to the first aspect, in a possible implementation, the reinforcing structure is disposed along an outer edge of the movable structure. The annular structure is configured to support an outer edge of the reflective structure, thereby enhancing structural strength of the outer edge, and reducing deformation of the reflective structure.

With reference to the first aspect, in a possible implementation, a driving manner of a drive structure is one of electrostatic driving, magnetoelectric driving, piezoelectric driving, and thermoelectric driving.

With reference to the first aspect, in a possible implementation, the driving manner of the drive structure is electrostatic driving. The drive structure includes a movable comb and a fastened comb, and the movable comb and the fastened comb are located around the movable structure. The movable comb is connected to the movable structure, and the fastened comb is connected to the fastened structure. A width of the drive structure is between 1 micrometer and 100 micrometers, and a length of the drive structure is between 20 micrometers and 1000 micrometers.

With reference to the first aspect, in a possible implementation, the driving manner of the drive structure is magnetoelectric driving. The two fastened structures further include two electrodes, and the movable portion further includes a metal coil. Two ends of the metal coil are respectively connected to two first metal conducting wires of the first cantilever beam and the second cantilever beam, and the two first metal conducting wires are respectively connected to the two electrodes.

With reference to the first aspect, in a possible implementation, the first cantilever beam and the second cantilever beam further include first metal conducting wires, the first metal conducting wires are configured to transmit an electrical signal, widths of the first metal conducting wires are less than a width of a middle of the cantilever beam, and thicknesses of the first metal conducting wires are not greater than 50 micrometers.

With reference to the first aspect, in a possible implementation, the first cantilever beam and the second cantilever beam are located at the first device layer and the second device layer, and projected areas of the first cantilever beam and the second cantilever beam at the first device layer are within projected areas of the first cantilever beam and the second cantilever beam at the second device layer. Because projections of the first cantilever beam and the second cantilever beam at the first device layer are within projections of the first cantilever beam and the second cantilever beam at the second device layer, stress concentration is not caused, thereby improving performance of a device.

With reference to the first aspect, in a possible implementation, the support portion further includes a first auxiliary beam, the first auxiliary beam is located at the first device layer, the first auxiliary beam and the first cantilever beam are located on a same side of the movable portion, the first auxiliary beam and the first cantilever beam do not overlap, and strength of the first auxiliary beam is less than strength of the first cantilever beam. One end of the first auxiliary beam is directly connected to the movable structure, and the other end of the first auxiliary beam is directly or indirectly connected to the first fastened layer. The first auxiliary beam is added to the support portion, so that strength of the support portion may be increased. In addition, the first auxiliary beam and the first cantilever beam are disposed in a staggered manner, so that when the first auxiliary beam is formed, influence (for example, etching influence) on the first cantilever beam is negligible, thereby reducing a process disadvantage and improving a product yield rate.

With reference to the first aspect, in a possible implementation, at least one first auxiliary beam is disposed on each of two opposite sides of the first cantilever beam. In this way, symmetry of the support portion may be improved, and rotation effect of the movable portion may be improved.

With reference to the first aspect, in a possible implementation, an overall thickness of the first auxiliary beam is less than the overall thickness of the first cantilever beam. In this way, influence of the first auxiliary beam on a function of the first cantilever beam may be reduced.

With reference to the first aspect, in a possible implementation, the first auxiliary beam is of a straight-line shape or a non-straight-line shape. A structure of the first auxiliary beam is flexible and changeable, so that applicability is strong.

With reference to the first aspect, in a possible implementation, the support portion further includes a second auxiliary beam, the second auxiliary beam is located at the first device layer, the second auxiliary beam and the second cantilever beam are located on a same side of the movable portion, the second auxiliary beam and the second cantilever beam do not overlap, and strength of the second auxiliary beam is less than strength of the second cantilever beam. One end of the second auxiliary beam is directly connected to the movable structure, and the other end of the second auxiliary beam is directly or indirectly connected to the first fastened layer. The second auxiliary beam is added to the support portion, so that strength of the support portion may be increased. In addition, the second auxiliary beam and the second cantilever beam are disposed in a staggered manner, so that when the second auxiliary beam is formed, influence (for example, etching influence) on the second cantilever beam is negligible, thereby reducing a process disadvantage and improving a product yield rate.

With reference to the first aspect, in a possible implementation, the MEMS micromirror system further includes a second metal conducting wire, the second metal conducting wire is disposed on a surface of the first auxiliary beam and/or a surface of the second auxiliary beam, the second metal conducting wire is configured to transmit an electrical signal, and a width of the second metal conducting wire is less than a width of the first auxiliary beam or the second auxiliary beam. This facilitates implementation of magnetoelectric driving.

With reference to the first aspect, in a possible implementation, the MEMS micromirror system further includes a third auxiliary beam and a fourth auxiliary beam. The third auxiliary beam is located at the first device layer, the third auxiliary beam and the third cantilever beam are located on a same side of the movable portion, the third auxiliary beam and the third cantilever beam do not overlap, strength of the third auxiliary beam is less than strength of the third cantilever beam, one end of the third auxiliary beam is connected to the movable outer frame, and the other end of the third auxiliary beam is connected to the first fastened layer. The fourth auxiliary beam is located at the first device layer, the fourth auxiliary beam and the fourth cantilever beam are located on a same side of the movable portion, the fourth auxiliary beam and the fourth cantilever beam do not overlap, strength of the fourth auxiliary beam is less than strength of the fourth cantilever beam, one end of the fourth auxiliary beam is connected to the movable outer frame, and the other end of the fourth auxiliary beam is connected to the first fastened layer. The third auxiliary beam and the third cantilever beam are disposed in a staggered manner, and the fourth auxiliary beam and the fourth cantilever beam are disposed in a staggered manner, so that when the third auxiliary beam and the fourth auxiliary beam are formed, influence (for example, etching influence) on the third cantilever beam and the fourth cantilever beam is negligible, thereby reducing a process disadvantage and improving a product yield rate.

According to a second aspect, an embodiment of the present invention provides a lidar system, including a light emitting apparatus, a reflector, a light receiving apparatus, and the MEMS micromirror system according to the first aspect.

The light emitting apparatus is configured to emit a laser pulse to the reflector.

The reflector is configured to turn the emitted laser pulse, so that the turned laser pulse is incident to the MEMS micromirror system.

The MEMS micromirror system is configured to change an emergent angle of the laser pulse, so that the laser pulse reaches a surface of a target detection obstacle after being emitted.

The light receiving apparatus is configured to receive a laser pulse diffusely reflected by the surface of the obstacle.

According to a third aspect, an embodiment of the present invention provides a vehicle. The vehicle includes the MEMS lidar system according to the second aspect.

### BRIEF DESCRIPTION OF DRAWINGS

FIG. 1 is a side view of a MEMS micromirror system 100 according to an embodiment of this application;
FIG. 2a is a diagram of a device layer of a MEMS micromirror system 100 according to an embodiment of this application;
FIG. 2b is a diagram of a device layer of another MEMS micromirror system 100 according to an embodiment of this application;
FIG. 3 is a diagram of a cantilever beam according to an embodiment of this application;
FIG. 4 is a diagram of another cantilever beam according to an embodiment of this application;
FIG. 5a, FIG. 5b, and FIG. 5c are diagrams of a MEMS dual-axis micromirror system according to an embodiment of this application;
FIG. 6 is a diagram of a cantilever beam of a non-straight-line shape according to an embodiment of this application;
FIG. 7 is a diagram of a reinforcing structure according to an embodiment of this application;
FIG. 8 is a diagram of a MEMS micromirror system whose driving manner is electrostatic driving according to an embodiment of this application;
FIG. 9 is a diagram of a MEMS micromirror system whose driving manner is magnetoelectric driving according to an embodiment of this application;
FIG. 10a is a diagram of a MEMS micromirror system according to an embodiment of this application;
FIG. 10b is a side view of a MEMS micromirror system according to an embodiment of this application;
FIG. 10c is a diagram of a MEMS micromirror system according to an embodiment of this application;
FIG. 11 is a diagram of a MEMS micromirror system according to an embodiment of this application;
FIG. 12 is a partial diagram of a MEMS micromirror system according to an embodiment of this application; and
FIG. 13 is a diagram of a MEMS dual-axis micromirror system according to an embodiment of this application.

It should be noted that the figures provided in the embodiments describe solutions of this application only in an example manner. Therefore, an equivalent apparatus or equivalent procedure alteration made by using the specification and accompanying drawings of this application, or an application of the specification and accompanying drawings directly or indirectly to another related technical field, shall fall within the patent protection scope of this application.

### DESCRIPTION OF EMBODIMENTS

To make objectives, technical solutions, and advantages of this application clearer, the following further describes embodiments of the present invention in detail with reference to accompanying drawings.

In the specification, claims, and accompanying drawings of this application, the terms "first", "second", and so on are intended to distinguish between similar objects but do not necessarily indicate a specific order or sequence. It should be understood that the terms used in such a way are interchangeable in proper circumstances, and this is merely a discrimination manner that is used when objects having a same attribute are described in embodiments of this application. In addition, the terms "include", "have", and any other variants are intended to cover the non-exclusive inclusion, so that a process, method, system, product, or device that includes a series of units is not necessarily limited to those units, but may include other units not expressly listed or inherent to such a process, method, product, or device.

To facilitate understanding of a micro-electro-mechanical system (Micro-Electro-Mechanical system, MEMS) provided in embodiments of this application, an application device and an application scenario of the micro-electro-mechanical system are described below. Due to advantages such as a small size, lightweight, low energy consumption, low inertia, a high resonance frequency, and a short response time, a MEMS device is widely applied to a mobile terminal, an event data recorder, a security protection device, or another electronic device that is likely to be affected by jitter during use and that has an image capture function. A MEMS device provided in the present invention may be applied to fields such as human-computer interaction, self-driving, AR/VR, image recognition, intelligent manufacturing, and intelligent robots.

A MEMS micromirror system, also referred to as a MEMS vibrating mirror system, is an optical MEMS device that integrates an optical reflector and a MEMS driver. A motion manner of the MEMS micromirror system is two mechanical motions: translation and rotation. MEMS drivers may be classified into manners such as electrostatic driving (ES), magnetoelectric driving (EM), piezoelectric driving (PE), and thermoelectric driving (ET) based on driving principles of the MEMS drivers. A driving manner in this application is not specifically limited herein. The MEMS micromirror system is driven to perform deflection, modulation, turn-on and turn-off, and phase control on an incident light beam. MEMS micromirror systems may be classified into single-axis, dual-axis, and multi-axis micromirror systems, and the like based on a quantity of axes, and may be classified into fast-axis and slow-axis micromirror systems, and the like based on a frequency. This is not limited herein.

The MEMS micromirror system usually includes a drive portion, a fastened portion, a movable portion, and a support portion. A bottom layer of a fastened structure is connected to the support portion, the other end of the support portion is connected to a reinforcing structure, the movable portion is disposed on a support structure, and the movable portion may rotate relative to the fastened portion under a driving action of a drive structure, to implement a related function of a MEMS chip.

When an existing MEMS micromirror system is subject to external impact, a movable portion is likely to undergo large displacement under the impact. Consequently, a support portion is excessively deformed and finally fractures, and structural reliability of a MEMS chip is affected.

In a special scenario, for example, a MEMS micromirror system is applied to a lidar. The MEMS micromirror system uses a reflector surface unit that is larger and thicker than another MEMS micromirror system, to make emergent optical pulses more focused and an emission distance longer. Consequently, a large-mirror-surface design reduces vibration resistance and impact resistance capabilities of the MEMS micromirror system, and is more likely to cause a support portion to fracture.

Based on this, embodiments of this application provide a MEMS micromirror system with higher reliability, especially a large-mirror-surface MEMS micromirror system. The following describes embodiments of this application in detail with reference to the accompanying drawings.

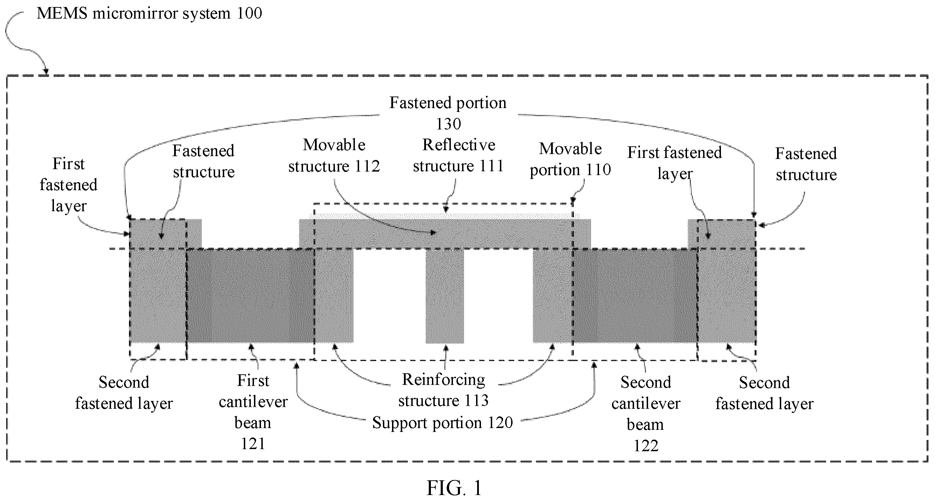

FIG. 1 is a side view of a MEMS micromirror system according to an embodiment of this application. The MEMS micromirror system 100 may be divided into a movable portion 110, a support portion 120, a fastened portion 130, and a drive portion according to functions. A drive structure is not shown in FIG. 1.

The movable portion 110 is located at a central position of an overall structure of the MEMS micromirror system 100, and may translate or rotate relative to the fastened portion 130 under an action of the drive structure. The movable portion 110 further includes a reflective structure 111, a movable structure 112, and a reinforcing structure 113.

The reflective structure 111 is attached above the movable structure 112. The reflective structure 111 is configured to reflect incident light. When the reflective structure 111 is deflected by a driving force, the reflected light is also deflected accordingly, thereby implementing a light deflection or modulation function. A specific material of the reflective structure 111 is not limited in this embodiment of this application. The material may be a metallic material, a silicate-type non-metallic material, or another reflective material.

The movable structure 112 is directly or indirectly connected to the reinforcing structure 113. Under an action of a driving force generated by the drive structure, the reflective structure 111 attached above the movable structure 112 is driven to translate or rotate relative to the fastened portion 130.

The reinforcing structure 113 is configured to support the movable structure 112 and the reflective structure 111. A material of the reinforcing structure 113 may be a silicon substrate, or may be a non-silicon substrate. The silicon substrate is used as an example. In this application, various microstructures, routing, and the like may be processed on the silicon substrate by using processing means such as etching, photoetching, and grinding that are commonly used in silicon micromechanical processing, to meet other requirements.

The support portion 120 includes a plurality of cantilever beams, and a total quantity of cantilever beams is an even multiple. Two ends of each cantilever beam are respectively connected to the reinforcing structure 113 and a second fastened layer. As an electromechanical movable element, the cantilever beam is deformed relative to a fastened structure under an action of an electrostatic force or another force when the MEMS micromirror system 100 works, so that the reflective structure 111 is deflected to a target state, to modulate an angle of incident light.

In a feasible manner, a first cantilever beam 121 and a second cantilever beam 122 may be made of a silicon material, and various microstructures are processed on the cantilever beams by using processing means such as etching, photoetching, and grinding that are commonly used in silicon micromechanical processing, to meet requirements such as routing or apparatus mounting.

In some embodiments, the support portion 120 includes the first cantilever beam 121 and the second cantilever beam 122. The first cantilever beam 121 and the second cantilever beam 122 are symmetrically disposed relative to a center of the movable portion, and are collinear to each other. One end of each of the two cantilever beams is connected to one side of the reinforcing structure 113, and the other end is connected to one of two second fastened layers.

The fastened portion 130 includes a plurality of fastened structures, and a total quantity of fastened structures is an even multiple. Each fastened structure further includes a first fastened layer and a second fastened layer. The first fastened layer is located above the second fastened layer, and an overall thickness of the first fastened layer is less than an overall thickness of the second fastened layer. The fastened portion 130 may be connected to an inner frame, or may be directly used as a part of the inner frame.

The second fastened layer of each fastened structure is directly or indirectly connected to one end of each of the first cantilever beam and the second cantilever beam, and overall thicknesses of the first cantilever beam 121 and the second cantilever beam 122 are greater than or equal to the overall thickness of the first fastened layer. The fastened portion 130 is not rotated or driven under an action of the drive structure.

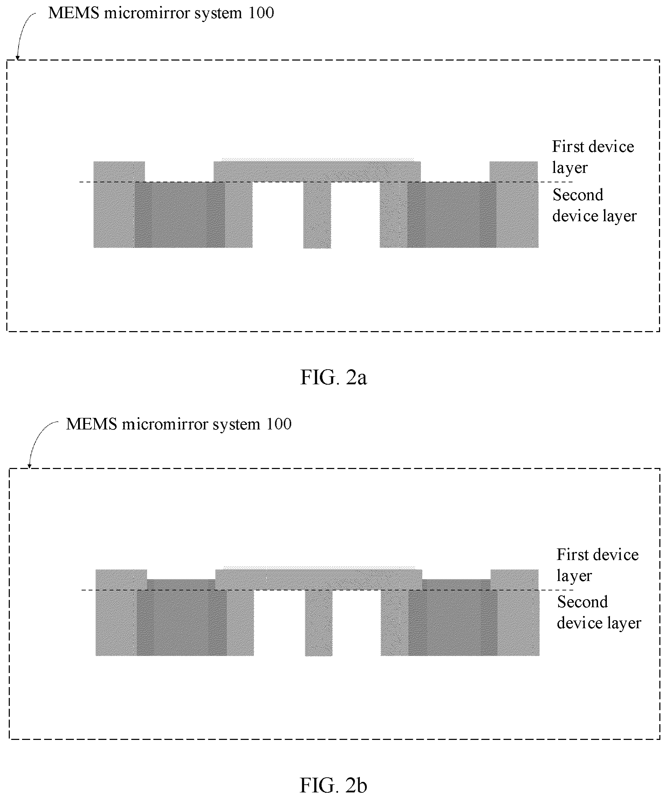

With reference to FIG. 2a, it may be learned that the MEMS micromirror system 100 may be divided into a first device layer and a second device layer according to structural positions. The first device layer and the second device layer may be directly or indirectly interconnected. The movable portion 110, the support portion 120, the fastened portion 130, and the drive portion jointly form the first device layer and the second device layer.

In some embodiments, the first device layer includes a plurality of first fastened layers, the movable structure 112, and the reflective structure 111; and the second device layer includes a plurality of second fastened layers, the reinforcing structure 113, and the plurality of cantilever beams.

In some other embodiments, refer to FIG. 2b. Similarly, the first device layer includes a plurality of first fastened layers, the movable structure 112, and the reflective structure 111; and the second device layer includes a plurality of second fastened layers and the reinforcing structure 113. Different from the embodiment shown in FIG. 2a, the plurality of cantilever beams are located at the first device layer and the second device layer, and thicknesses of the cantilever beams located at the first device layer are not greater than thicknesses of the cantilever beams located at the second device layer. In either of the embodiments provided in FIG. 2a and FIG. 2b, an overall thickness of the first device layer is not greater than an overall thickness of the second device layer, and the overall thickness is a maximum thickness of each compositional structure in the device layer in a vertical direction.

As a carrier of the entire micromirror system, the second device layer is preferably made of a material with good insulation. An applicable material may be a silicon chip material including silicon dioxide, or a conducting material that has undergone surface oxidation processing, or may be another insulating material.

It should be noted that the accompanying drawings in FIG. 2a and FIG. 2b are merely used as examples for reference, and do not limit a specific size of the MEMS micromirror system 100. For example, overall thicknesses of the plurality of first fastened layers and the movable structure 112 may be equal or different, and overall thicknesses of the plurality of second fastened layers, the plurality of cantilever beams, and the reinforcing structure 113 may be equal or different. This is not limited herein.

In some embodiments, the overall thickness of the second device layer is greater than the overall thickness of the first device layer, and is less than twice the overall thickness of the first device layer. In this embodiment of this application, compared with a conventional technology, a thickness at a boundary of the cantilever beam does not change greatly, and rigidity is relatively continuous, so that stress concentration is not caused.

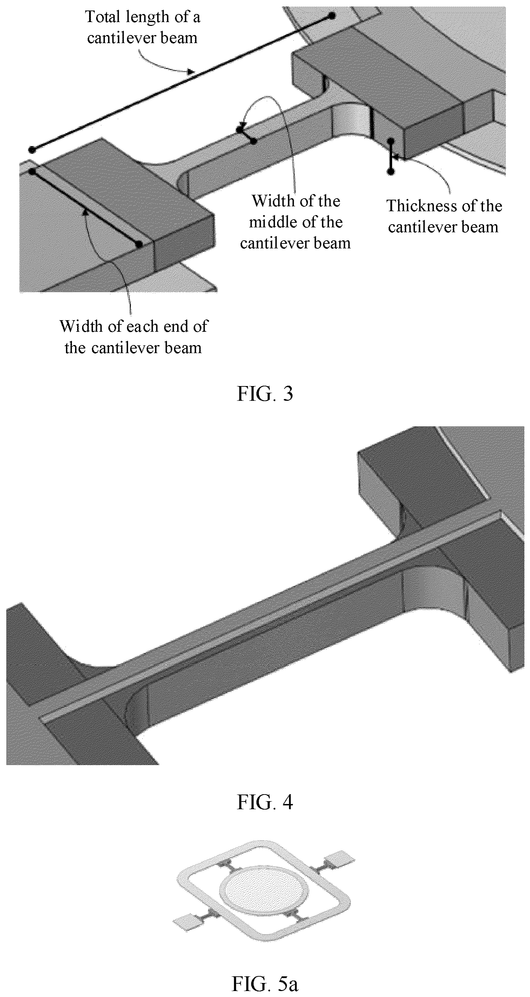

When the MEMS micromirror system 100 is subject to external impact, because the support portion 120 is connected to the thicker reinforcing structure 113 and the thicker second fastened layer, impact resistance and vibration resistance capabilities of the MEMS micromirror system may be effectively improved. FIG. 3 is an enlarged diagram of the first cantilever beam 121. The first cantilever beam 121 is used as an example. Widths of connection structures at two ends of the first cantilever beam 121 are greater than a width of a middle of the first cantilever beam 121. One of the connection structures at two ends of the cantilever beam is directly connected to the reinforcing structure 113, and the other one is directly or indirectly connected to the second fastened layer.

In some embodiments, a thickness of the cantilever beam is not less than 100 micrometers, the width of the middle is not less than 20 micrometers, and a total length of the cantilever beam is between 0.5 millimeters and 10 millimeters.

FIG. 4 is a diagram of a cantilever beam in FIG. 2b. It may be learned from FIG. 4 that the cantilever beam is located at both the first device layer and the second device layer, and a thickness of the cantilever beam located at the first device layer is not greater than a thickness of the cantilever beam located at the second device layer. In addition, a projected area of the cantilever beam located at the first device layer is within a projected area of the cantilever beam located at the second device layer. Two ends of the cantilever beam located at the first device layer are respectively connected to the first fastened layer and the movable portion.

In some embodiments, the cantilever beam at the first device layer further includes a first metal conducting wire. One end of the first metal conducting wire is connected to the first fastened layer, and the other end is connected to the movable portion. The first metal conducting wire is configured to transmit an electrical signal, and may also be configured to generate an electromagnetic driving force.

A thickness of the first metal conducting wire is less than 50 micrometers, and a material of the first metal conducting wire may be metal such as gold, aluminum, or copper, or a composite material of these metals.

In some embodiments, the first metal conducting wire may be additionally disposed in internal grooves of the first cantilever beam 121 and the second cantilever beam 122, and two ends of the first metal conducting wire are respectively connected to the second fastened layer and the reinforcing structure 113.

FIG. 5a is a diagram of a first MEMS dual-axis micromirror system. The MEMS micromirror system further includes a movable outer frame, a third cantilever beam, and a fourth cantilever beam.

As shown in FIG. 5a, one end of each of the first cantilever beam and the second cantilever beam is not directly connected to the second fastened layer in the fastened portion, but is indirectly connected to the second fastened layer through the movable outer frame, and the other end is directly connected to the reinforcing structure.

One end of each of the third cantilever beam and the fourth cantilever beam is directly connected to the movable outer frame, and the other end is directly connected to the second fastened layer.

The third cantilever beam and the fourth cantilever beam may be included in only the first device layer or the second device layer, or may be included in both the first device layer and the second device layer.

In some embodiments, physical structures such as sizes and structures of the third cantilever beam and the fourth cantilever beam are consistent with those of the first cantilever beam and the second cantilever beam. That is, the third cantilever beam and the fourth cantilever beam meet features such as a width of each end being greater than a width of a middle, thicknesses of the third cantilever beam and the fourth cantilever beam being not less than 100 micrometers, the width of the middle being not less than 20 micrometers, and a total length of the cantilever beam being between 0.5 millimeters and 10 millimeters.

Because a structure of the cantilever beam made of a silicon-based material is very fragile, and fast and slow axes simultaneously perform reverse torsion on a micro vibrating mirror, external vibration or impact is very likely to cause the cantilever beam to fracture. All cantilever beams in this embodiment use the foregoing structural features, thereby greatly improving overall reliability of the MEMS micromirror system.

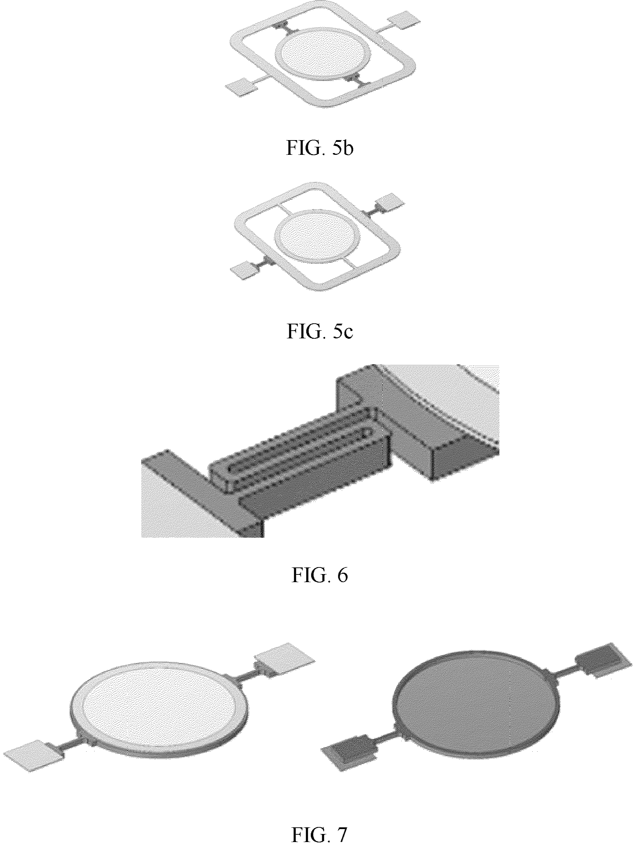

FIG. 5b is a diagram of a second MEMS dual-axis micromirror system. In this embodiment, physical structures such as sizes and structures of the third cantilever beam and the fourth cantilever beam are not specifically limited. The first cantilever beam and the second cantilever beam meet features such as a width of each end being greater than a width of a middle, thicknesses of the first cantilever beam and the second cantilever beam being not less than 100 micrometers, the width of the middle being not less than 20 micrometers, and a total length of the cantilever beam being between 0.5 millimeters and 10 millimeters. That is, the physical structures such as sizes and structures of the third cantilever beam and the fourth cantilever beam are different from those of the first cantilever beam and the second cantilever beam.

The first cantilever beam and the second cantilever beam are used as a fast axis of the MEMS dual-axis micromirror system, and have features of a higher rotation frequency, a smaller torsion angle, a larger width, and a shorter length compared with the third cantilever beam and the fourth cantilever beam. The third cantilever beam and the fourth cantilever beam are used as a slow axis of the MEMS dual-axis micromirror system, and have features of a lower rotation frequency, a larger torsion angle, a smaller width, and a longer length.

FIG. 5c is a diagram of a third MEMS dual-axis micromirror system. In this embodiment, physical structures such as sizes and structures of the first cantilever beam and the second cantilever beam are not specifically limited. The third cantilever beam and the fourth cantilever beam meet features such as a width of each end being greater than a width of a middle, thicknesses of the third cantilever beam and the fourth cantilever beam being not less than 100 micrometers, the width of the middle being not less than 20 micrometers, and a total length of the cantilever beam being between 0.5 millimeters and 10 millimeters.

The first cantilever beam and the second cantilever beam are used as a fast axis of the MEMS dual-axis micromirror system, and have features of a higher rotation frequency, a smaller torsion angle, a larger width, and a shorter length compared with the third cantilever beam and the fourth cantilever beam. The third cantilever beam and the fourth cantilever beam are used as a slow axis of the MEMS dual-axis micromirror system, and have features of a higher rotation frequency, a larger torsion angle, a smaller width, and a longer length.

It should be noted that FIG. 5a, FIG. 5b, and FIG. 5c are merely examples of accompanying drawings of the MEMS dual-axis micromirror system, and do not reflect a real scale of the MEMS micromirror system.

FIG. 6 is a diagram of a cantilever beam. Any quantity of cantilever beams in the first cantilever beam, the second cantilever beam, the third cantilever beam, and the fourth cantilever beam may be of a non-straight-line shape.

In some embodiments, the non-straight-line shape may be a folded structure. It is worth mentioning that any design in which an effective length of a cantilever beam is greater than an actual length of the cantilever beam may be considered as a non-straight-line structure. The actual length is a length of the cantilever beam in a static state under no external force, and the effective length is a maximum length of the cantilever beam that can be extended under stress.

FIG. 7 is a diagram of a reinforcing structure. The reinforcing structure is an annular closed structure. A projected area of the movable structure is within the annular closed structure.

In some embodiments, the reinforcing structure is disposed around an outer edge of the movable structure, and is configured to support the movable structure.

Driving manners of the MEMS micromirror system may be classified into electrostatic driving (ES), magnetoelectric driving (EM), piezoelectric driving (PE), thermoelectric driving (ET), and the like based on driving principles.

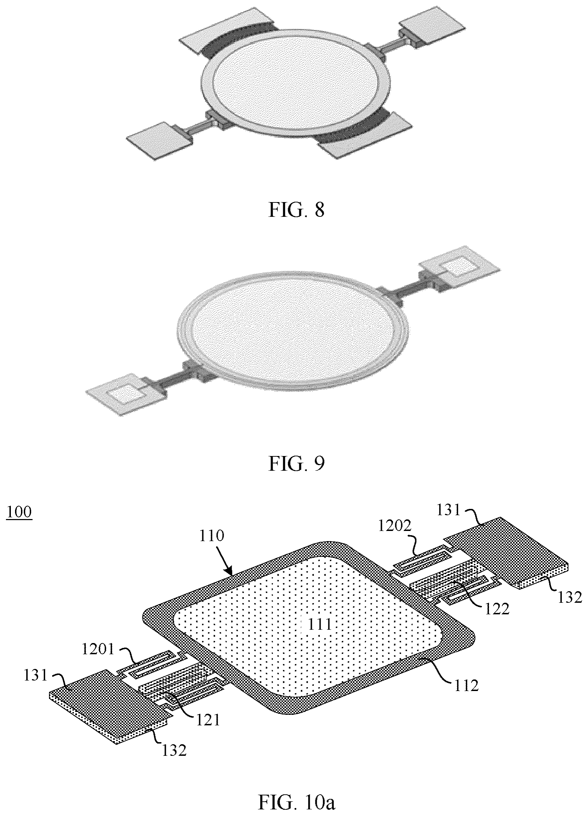

Refer to FIG. 8. In an embodiment, the driving manner of the MEMS micromirror system is electrostatic driving. The electrostatic drive structure is located at the first device layer, and the electrostatic drive structure is a comb-shaped drive structure, including a plurality of groups of movable combs and fastened combs. The movable combs and the fastened combs are arranged in a staggered manner to form the drive structure together.

The movable combs are distributed around the movable structure 112, and are connected to the movable structure 112. The fastened combs are connected to the fastened portion 130.

A width of the drive structure is between 1 micrometer and 100 micrometers, and a length of the drive structure is between 20 micrometers and 500 micrometers.

Specifically, a drive electrode group is built in the MEMS micromirror system 100 as a drive apparatus of the entire micromirror system. Different periodic voltages are applied to each electrode, so that the drive electrode group generates an electrostatic force on the movable portion 110, thereby causing the movable portion 110 to deflect at different angles and directions. By adjusting a frequency and an amplitude of the periodic voltage of each electrode, a magnitude of a driving force and a resonance frequency may be further adjusted. All electrodes are disposed opposite to each other in pairs with a center of the reflective structure 111 as an origin. Two opposite electrodes are used as a group, and at least one electrode in the group is electrified, to generate a driving force to control vibration of the reflective structure. It should be further noted that, in this embodiment of this application, only one of the plurality of electrodes may generate an acting force, or two or more adjacent electrodes may simultaneously generate an acting force, so that the movable portion 110 is in a target deflection state. When no voltage is applied to the plurality of electrodes, the movable portion 110 remains in an initial state.

The cantilever beam is configured to: when none of the N electrodes generates an acting force, enable a micro reflector to remain in an initial state; when at least one of the N electrodes generates an acting force, enable the micro reflector to be in a target deflection state; and when the acting force is zero, restore the micro reflector to the initial state. A cavity space is formed between the micro reflector and a base, the N electrodes and M stoppers are disposed in the cavity space, and the N electrodes and the M stoppers are fastened to the base. At least one of the N electrodes is configured to generate an acting force to control the micro reflector to enter a deflection state. The micro reflector is configured to enter the deflection state under the acting force of the at least one of the N electrodes. At least one of the M stoppers is configured to stop the micro reflector, so that the micro reflector stops at the target deflection state.

Refer to FIG. 9. In another embodiment, the driving manner of the MEMS micromirror system is magnetoelectric driving. The movable portion 110 further includes a metal film layer and an inductor coil group. The metal film layer is located on the back of the movable structure 112, the inductor coil group is located right below the metal film layer, and the inductor coil keeps a specific distance from the metal film. The inductor coil group may be a half coil or a plurality of coils, and the metal film layer may be replaced with a permanent magnet. This is not limited herein.

In some embodiments, the inductor coil group includes at least a first inductor coil and a second inductor coil. The first inductor coil provides a magnetic force for x-axis deflection of the movable portion 110, and the second inductor coil provides a magnetic force for y-axis deflection. Current signals applied to the two coils are independent of each other.

The foregoing two driving manners are merely examples for description, and do not limit the solutions of this application.

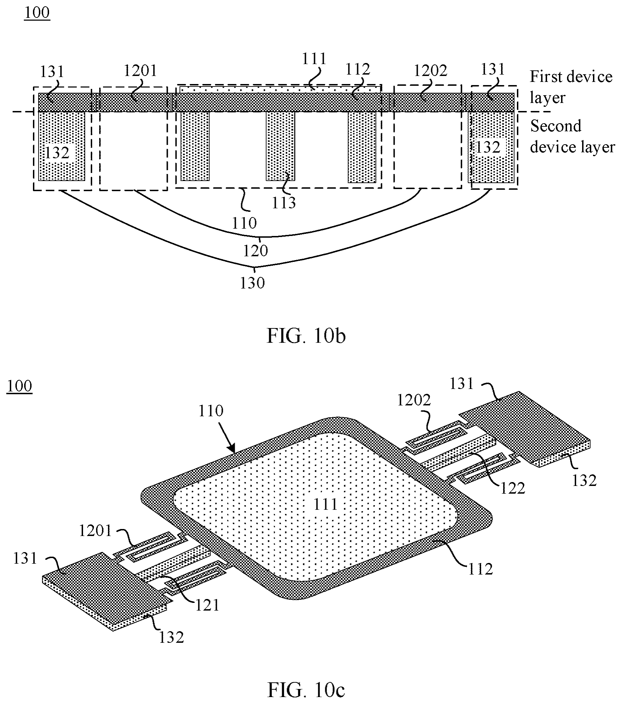

In some embodiments, with reference to FIG. 10a and FIG. 10b, the support portion 120 includes the first cantilever beam 121 and the second cantilever beam 122. On this basis, the support portion 120 further includes a first auxiliary beam 1201. The first auxiliary beam 1201 is located at the first device layer, and the first cantilever beam 121 and the second cantilever beam 122 are located at the second device layer.

The first auxiliary beam 1201 and the first cantilever beam 121 are located on a same side of the movable portion 110, and the first auxiliary beam 1201 and the first cantilever beam 121 do not overlap. Alternatively, it is understood that a projection of the first auxiliary beam 1201 on a plane on which the first device layer is located does not overlap a projection of the first cantilever beam 121 on the plane on which the first device layer is located. That is, the first auxiliary beam 1201 is not located right above the first cantilever beam 121.

The fastened portion 130 includes a first fastened layer 131 and a second fastened layer 132. One end of the first auxiliary beam 1201 is directly connected to the movable structure 112, and the other end of the first auxiliary beam 1201 is directly or indirectly connected to the first fastened layer 131. In FIG. 10a, an example in which the other end of the first auxiliary beam 1201 is directly connected to the first fastened layer 131 is used for illustration. An example in which the other end of the first auxiliary beam 1201 is indirectly connected to the first fastened layer 131 is described below.

In some embodiments, strength of the first auxiliary beam 1201 is less than strength of the first cantilever beam 121.

For example, an overall thickness of the first auxiliary beam 1201 is less than the overall thickness of the first cantilever beam 121. For example, the first auxiliary beam 1201 is a straight-line structure.

Alternatively, for example, an extension length of the first auxiliary beam 1201 is greater than an extension length of the first cantilever beam 121. For example, the first auxiliary beam 1201 is a non-straight-line structure. Optionally, the first auxiliary beam 1201 extends along a fold line (for example, a U-shaped bending manner or a Z-shaped bending manner), and a quantity of folds of the first auxiliary beam 1201 is greater than a quantity of folds of the first cantilever beam 121. Alternatively, optionally, the first auxiliary beam 1201 extends along a curve, and a radian of the first auxiliary beam 1201 is greater than a radian of the first cantilever beam 121.

The strength of the first auxiliary beam 1201 is made less than the strength of the first cantilever beam 121, so that influence of the first auxiliary beam 1201 on performance of the first cantilever beam 121 may be reduced, and the first cantilever beam 121 is still a main cantilever control structure.

In some embodiments, still refer to FIG. 10a and FIG. 10b. The support portion 120 further includes a second auxiliary beam 1202. The second auxiliary beam 1202 is located at the first device layer.

The second auxiliary beam 1202 and the second cantilever beam 122 are located on a same side of the movable portion 110, and the second auxiliary beam 1202 and the second cantilever beam 122 do not overlap. Alternatively, it is understood that a projection of the second auxiliary beam 1202 on a plane on which the first device layer is located does not overlap a projection of the second cantilever beam 122 on the plane on which the first device layer is located. That is, the second auxiliary beam 1202 is not located right above the second cantilever beam 122.

One end of the second auxiliary beam 1202 is directly connected to the movable structure 112, and the other end of the second auxiliary beam 1202 is directly or indirectly connected to the first fastened layer 131. In FIG. 10a, an example in which the other end of the second auxiliary beam 1202 is directly connected to the first fastened layer 131 is used for illustration. An example in which the other end of the second auxiliary beam 1202 is indirectly connected to the first fastened layer 131 is described below.

In some embodiments, strength of the second auxiliary beam 1202 is less than strength of the second cantilever beam 122. For a relative relationship between the second auxiliary beam 1202 and the second cantilever beam 122, refer to the foregoing related description about the relative relationship between the first auxiliary beam 1201 and the first cantilever beam 121. Details are not described herein again.

In this embodiment of this application, the first auxiliary beam 1201 and the second auxiliary beam 1202 are added to the support portion 120, so that strength of the support portion 120 may be increased. In addition, the first auxiliary beam 1201 and the first cantilever beam 121 are disposed in a staggered manner, and the second auxiliary beam 1202 and the second cantilever beam 122 are disposed in a staggered manner, so that when the first auxiliary beam 1201 and the second auxiliary beam 1202 are formed, influence (for example, etching influence) on the first cantilever beam 121 and the second cantilever beam 122 is negligible, thereby reducing a process disadvantage and improving a product yield rate.

As shown in FIG. 10a and FIG. 10c, a structure of the first cantilever beam 121 is not limited in this embodiment of this application. The first cantilever beam 121 may be any one of the foregoing structures of the first cantilever beam 121. The following uses only an example in which the first cantilever beam 121 is a non-straight-line structure for description.

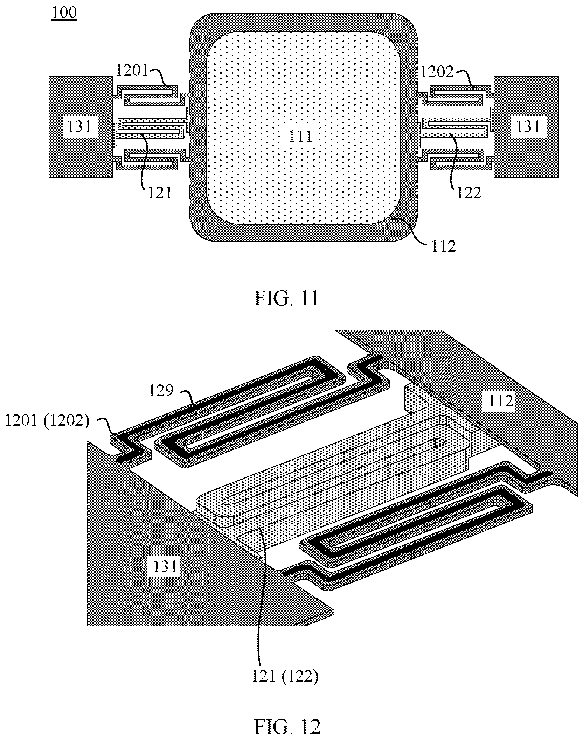

In some embodiments, refer to FIG. 11. At least one first auxiliary beam 1201 is disposed on each of two opposite sides of the first cantilever beam 121. FIG. 11 illustrates an example in which one first auxiliary beam 1201 is disposed on each of two opposite sides of the first cantilever beam 121. One or more first auxiliary beams 1201 may be disposed on each side of the first cantilever beam 121.

In some embodiments, at least one second auxiliary beam 1202 is disposed on each of two opposite sides of the second cantilever beam 122. FIG. 11 illustrates an example in which one second auxiliary beam 1202 is disposed on each of two opposite sides of the second cantilever beam 122. One or more second auxiliary beams 1202 may be disposed on each side of the second cantilever beam 122.

In some embodiments, refer to FIG. 12. The MEMS micromirror system further includes a second metal conducting wire 129, and the second metal conducting wire 129 is configured to transmit an electrical signal.

For example, the second metal conducting wire 129 is disposed on a surface (a side away from the second device layer) of the first auxiliary beam 1201, and a width of the second metal conducting wire 129 is less than a width of the first auxiliary beam 1201. Widths of the first auxiliary beam 1201 at various positions may be equal or unequal. When the widths of the first auxiliary beam 1201 at various positions are unequal, the width of the second metal conducting wire 129 only needs to be less than a width of the first auxiliary beam 1201 below the second metal conducting wire 129. That is, the first auxiliary beam 1201 can carry the second metal conducting wire 129.

When the support portion 120 includes a plurality of first auxiliary beams 1201, the second metal conducting wire 129 may be disposed on a surface of one first auxiliary beam 1201, or the second metal conducting wire 129 may be disposed on surfaces of a plurality of first auxiliary beams 1201.

In some embodiments, the first auxiliary beam 1201 and the second auxiliary beam 1202 are symmetrically disposed on two sides of the movable portion 110. In this way, symmetry of the support portion 120 may be improved, and rotation effect of the movable portion 110 may be improved.

For example, the second metal conducting wire 129 is disposed on a surface (a side away from the second device layer) of the second auxiliary beam 1202, and a width of the second metal conducting wire 129 is less than a width of the second auxiliary beam 1202. Widths of the second auxiliary beam 1202 at various positions may be equal or unequal. When the widths of the second auxiliary beam 1202 at various positions are unequal, the width of the second metal conducting wire 129 only needs to be less than a width of the second auxiliary beam 1202 below the second metal conducting wire 129. That is, the second auxiliary beam 1202 can carry the second metal conducting wire 129.

When the support portion 120 includes a plurality of second auxiliary beams 1202, the second metal conducting wire 129 may be disposed on a surface of one second auxiliary beam 1202, or the second metal conducting wire 129 may be disposed on surfaces of a plurality of second auxiliary beams 1202.

For example, electrodes are respectively disposed on surfaces of two first fastened layers 131, and a metal coil is further disposed on a surface of the movable portion 110. Two ends of the metal coil are respectively connected to the second metal conducting wires 129 on the surfaces of the first auxiliary beam 1201 and the second auxiliary beam 1202, and the second metal conducting wires 129 on the surfaces of the first auxiliary beam 1201 and the second auxiliary beam 1202 are respectively connected to the electrodes on the surfaces of the first fastened layers 131, to form a magnetoelectric drive system.

In some embodiments, the second metal conducting wires 129 are symmetrically disposed on two sides of the movable portion 110. In this way, symmetry of the support portion 120 may be improved, and rotation effect of the movable portion 110 may be improved.

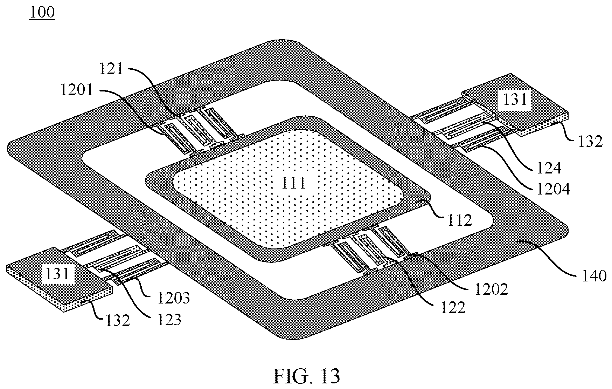

In some embodiments, refer to FIG. 13. The MEMS micromirror system 100 further includes a third auxiliary beam 1203.

The third auxiliary beam 1203 is located at the first device layer, the third auxiliary beam 1203 and the third cantilever beam 123 are located on a same side of the movable portion 110, and the third auxiliary beam 1203 and the third cantilever beam 123 do not overlap. One end of the third auxiliary beam 1203 is connected to the movable outer frame 140, and the other end of the third auxiliary beam 1203 is connected to the first fastened layer 131. Strength of the third auxiliary beam 1203 is less than strength of the third cantilever beam 123. For a structure of the third auxiliary beam 1203 and a structural relationship between the third auxiliary beam 1203 and the third cantilever beam 123, refer to the foregoing related description about the structure of the first auxiliary beam 1201 and the structural relationship between the first auxiliary beam 1201 and the first cantilever beam 121. Details are not described herein again.

In some embodiments, refer to FIG. 13. The MEMS micromirror system 100 further includes a fourth auxiliary beam 1204.

The fourth auxiliary beam 1204 is located at the first device layer, the fourth auxiliary beam 1204 and the fourth cantilever beam 124 are located on a same side of the movable portion 110, and the fourth auxiliary beam 1204 and the fourth cantilever beam 124 do not overlap. One end of the fourth auxiliary beam 1204 is connected to the movable outer frame 140, and the other end of the fourth auxiliary beam 1204 is connected to the first fastened layer 131. Strength of the fourth auxiliary beam 1204 is less than strength of the fourth cantilever beam 124. For a structure of the fourth auxiliary beam 1204 and a structural relationship between the fourth auxiliary beam 1204 and the fourth cantilever beam 124, refer to the foregoing related description about the structure of the first auxiliary beam 1201 and the structural relationship between the first auxiliary beam 1201 and the first cantilever beam 121. Details are not described herein again.

The third auxiliary beam 1203 and the third cantilever beam 123 are disposed in a staggered manner, and the fourth auxiliary beam 1204 and the fourth cantilever beam 124 are disposed in a staggered manner, so that when the third auxiliary beam 1203 and the fourth auxiliary beam 1204 are formed, influence (for example, etching influence) on the third cantilever beam 123 and the fourth cantilever beam 124 is negligible, thereby reducing a process disadvantage and improving a product yield rate.

In some embodiments, the MEMS micromirror system further includes a third metal conducting wire, and the third metal conducting wire is configured to transmit an electrical signal. The third metal conducting wire is disposed on a surface of the third auxiliary beam 1203. A width of the third metal conducting wire is less than a width of a middle of the third auxiliary beam 1203. The third metal conducting wire is disposed on a surface of the fourth auxiliary beam 1204. The width of the third metal conducting wire is less than a width of a middle of the fourth auxiliary beam 1204.

For example, a fourth metal conducting wire is disposed on the outer frame 140, and the third metal conducting wire, the fourth metal conducting wire, and the second metal conducting wire are interconnected to form a signal path.

The foregoing descriptions are merely some embodiments of this application, and are not intended to limit the protection scope of this application. An equivalent apparatus or equivalent procedure alteration made by using the specification and accompanying drawings of this application, or an application of the specification and accompanying drawings directly or indirectly to another related technical field, shall fall within the patent protection scope of this application.

## Claims

1. A MEMS micromirror system, wherein the MEMS micromirror system comprises:
a drive portion, a movable portion, a fastened portion, and a support portion;
the movable portion further comprises a movable structure, a reflective structure, and a reinforcing structure;
the drive portion is configured to drive the movable structure to translate or rotate relative to the fastened portion;
the fastened portion comprises at least two fastened structures, and each fastened structure comprises a first fastened layer and a second fastened layer;
the first fastened layer is located above the second fastened layer, and an overall thickness of the first fastened layer is less than an overall thickness of the second fastened layer; and
the support portion comprises at least a first cantilever beam and a second cantilever beam; one end of each of the first cantilever beam and the second cantilever beam is directly connected to the reinforcing structure, and the other end is directly or indirectly connected to the second fastened layer; and overall thicknesses of the first cantilever beam and the second cantilever beam are greater than or equal to the overall thickness of the first fastened layer, and are greater than an overall thickness of the movable structure.

2. The MEMS micromirror system according to claim 1, wherein
the reflective structure is located above the movable structure and is attached to the movable structure, and the reflective structure is configured to implement light deflection and modulation functions; and
the reinforcing structure is located below the movable structure and is configured to support the movable structure, and an overall thickness of the reinforcing structure is greater than the overall thickness of the movable structure.

3. The MEMS micromirror system according to claim 1 or 2, wherein
the reflective structure, the movable structure, and the first fastened layer are located at a first device layer, and the reinforcing structure and the second fastened layer are located at a second device layer; and
an overall thickness of the first device layer is less than an overall thickness of the second device layer.

4. The MEMS micromirror system according to any one of claims 1 to 3, wherein
the MEMS micromirror system further comprises a movable outer frame, a third cantilever beam, and a fourth cantilever beam;
one end of each of the third cantilever beam and the fourth cantilever beam is directly connected to the movable outer frame, and the other end is directly connected to the second fastened layer; and
one end of each of the first cantilever beam and the second cantilever beam is indirectly connected to the second fastened layer through the movable outer frame, the third cantilever beam, and the fourth cantilever beam, and the other end is directly connected to the reinforcing structure.

5. The MEMS micromirror system according to any one of claims 1 to 4, wherein a width of each end of any one or more of the first cantilever beam, the second cantilever beam, the third cantilever beam, and the fourth cantilever beam is greater than a width of a middle.

6. The MEMS micromirror system according to any one of claims 1 to 5, wherein a thickness of any one or more of the first cantilever beam, the second cantilever beam, the third cantilever beam, and the fourth cantilever beam is not less than 100 micrometers, the width of the middle is not less than 20 micrometers, and a total length is between 0.5 millimeters and 10 millimeters.

7. The MEMS micromirror system according to any one of claims 1 to 6, wherein a structure of any one or more of the first cantilever beam, the second cantilever beam, the third cantilever beam, and the fourth cantilever beam is of a straight-line shape or a non-straight-line shape.

8. The MEMS micromirror system according to any one of claims 1 to 7, wherein an area of the reflective structure is not greater than an area of the movable structure.

9. The MEMS micromirror system according to any one of claims 1 to 8, wherein the reinforcing structure is an annular closed structure.

10. The MEMS micromirror system according to claim 9, wherein the reinforcing structure is disposed along an outer edge of the movable structure.

11. The MEMS micromirror system according to any one of claims 1 to 10, wherein
a driving manner of the drive structure is one of electrostatic driving, magnetoelectric driving, piezoelectric driving, and thermoelectric driving.

12. The MEMS micromirror system according to claim 11, wherein
the driving manner of the drive structure is electrostatic driving;
the drive structure comprises a movable comb and a fastened comb, and the movable comb and the fastened comb are located around the movable structure;
the movable comb is connected to the movable structure, and the fastened comb is connected to the fastened structure; and
a width of the drive structure is between 1 micrometer and 100 micrometers, and a length of the drive structure is between 20 micrometers and 1000 micrometers.

13. The MEMS micromirror system according to claim 12, wherein
the first cantilever beam and the second cantilever beam further comprise first metal conducting wires, the first metal conducting wires are configured to transmit an electrical signal, widths of the first metal conducting wires are less than a width of a middle of the first cantilever beam, and thicknesses of the first metal conducting wires are not greater than 50 micrometers.

14. The MEMS micromirror system according to claim 13, wherein
the driving manner of the drive structure is magnetoelectric driving;
the two fastened structures further comprise two electrodes, and the movable portion further comprises a metal coil; and
two ends of the metal coil are respectively connected to the first metal conducting wires of the first cantilever beam and the second cantilever beam, and the two first metal conducting wires are respectively connected to the two electrodes.

15. The MEMS micromirror system according to claim 14, wherein
the first cantilever beam and the second cantilever beam are located at the first device layer and the second device layer, and projected areas of the first cantilever beam and the second cantilever beam at the first device layer are within projected areas of the first cantilever beam and the second cantilever beam at the second device layer; and
the first metal conducting wires are located on surfaces, at the first device layer, of the first cantilever beam and the second cantilever beam.

16. The MEMS micromirror system according to any one of claims 1 to 14, wherein
the support portion further comprises a first auxiliary beam, the first auxiliary beam is located at the first device layer, the first auxiliary beam and the first cantilever beam are located on a same side of the movable portion, the first auxiliary beam and the first cantilever beam do not overlap, and strength of the first auxiliary beam is less than strength of the first cantilever beam; and
one end of the first auxiliary beam is directly connected to the movable structure, and the other end of the first auxiliary beam is directly or indirectly connected to the first fastened layer.

17. The MEMS micromirror system according to claim 16, wherein at least one first auxiliary beam is disposed on each of two opposite sides of the first cantilever beam.

18. The MEMS micromirror system according to claim 16 or 17, wherein an overall thickness of the first auxiliary beam is less than the overall thickness of the first cantilever beam.

19. The MEMS micromirror system according to any one of claims 16 to 18, wherein the first auxiliary beam is of a straight-line shape or a non-straight-line shape.

20. The MEMS micromirror system according to any one of claims 1 to 14 and 16 to 19, wherein the support portion further comprises a second auxiliary beam, the second auxiliary beam is located at the first device layer, the second auxiliary beam and the second cantilever beam are located on a same side of the movable portion, the second auxiliary beam and the second cantilever beam do not overlap, and strength of the second auxiliary beam is less than strength of the second cantilever beam; and
one end of the second auxiliary beam is directly connected to the movable structure, and the other end of the second auxiliary beam is directly or indirectly connected to the first fastened layer.

21. The MEMS micromirror system according to claim 20, wherein the MEMS micromirror system further comprises a second metal conducting wire, the second metal conducting wire is disposed on a surface of the first auxiliary beam and/or a surface of the second auxiliary beam, the second metal conducting wire is configured to transmit an electrical signal, and a width of the second metal conducting wire is less than a width of the first auxiliary beam or the second auxiliary beam.

22. The MEMS micromirror system according to any one of claims 4 to 14 and 16 to 21, wherein the MEMS micromirror system further comprises a third auxiliary beam and a fourth auxiliary beam;
the third auxiliary beam is located at the first device layer, the third auxiliary beam and the third cantilever beam are located on a same side of the movable portion, the third auxiliary beam and the third cantilever beam do not overlap, strength of the third auxiliary beam is less than strength of the third cantilever beam, one end of the third auxiliary beam is connected to the movable outer frame, and the other end of the third auxiliary beam is connected to the first fastened layer; and
the fourth auxiliary beam is located at the first device layer, the fourth auxiliary beam and the fourth cantilever beam are located on a same side of the movable portion, the fourth auxiliary beam and the fourth cantilever beam do not overlap, strength of the fourth auxiliary beam is less than strength of the fourth cantilever beam, one end of the fourth auxiliary beam is connected to the movable outer frame, and the other end of the fourth auxiliary beam is connected to the first fastened layer.

23. A lidar system, comprising a light emitting apparatus, a reflector, a light receiving apparatus, and the MEMS micromirror system according to any one of claims 1 to 22, wherein
the light emitting apparatus is configured to emit a laser pulse to the reflector;
the reflector is configured to turn the emitted laser pulse, so that the turned laser pulse is incident to the MEMS micromirror system;
the MEMS micromirror system is configured to change an emergent angle of the laser pulse, so that the laser pulse reaches a surface of a target detection obstacle after being emitted; and
the light receiving apparatus is configured to receive a laser pulse diffusely reflected by the surface of the obstacle.

24. A vehicle, wherein the vehicle comprises the lidar system according to claim 23.
